# EUROPÄISCHE PATENTSCHRIFT

(11) **EP 0 992 001 B1**
(45) Veröffentlichungstag und Bekanntmachung des Hinweises auf die Patenterteilung: **14.11.2001**
(21) Anmeldenummer: 98936204.1
(22) Anmeldetag: 17.06.1998
(51) Int. Cl.: G06F 13/40

(54) **BAUGRUPPENTRÄGER MIT EINER GEDRUCKTE LEITERBAHNEN FÜHRENDEN RÜCKWANDLEITERPLATTE**
HOUSING INCLUDING A BACK PANEL FOR GUIDING CONDUCTIVE PRINTED TRACKS
BATI COMPORTANT UN FOND DE PANIER GUIDANT DES TRACES CONDUCTEURS IMPRIMES

(30) Priorität: 26.06.1997 DE 19727228
(43) Veröffentlichungstag der Anmeldung: 12.04.2000
(73) Patentinhaber: SIEMENS AKTIENGESELLSCHAFT, 80333 München (DE)
(72) Erfinder: OLWITZ, Rudolf, D-81476 München (DE)
(86) Internationale Anmeldenummer: DE9801660
(87) Internationale Veröffentlichungsnummer: WO9900742

(56) Entgegenhaltungen:
- US-A- 4 811 275
- US-A- 4 882 702
- US-A- 5 463 772

## Beschreibung

Die Erfindung betrifft einen Baugruppenträger mit einer gedruckte Leiterbahnen führenden Rückwandleiterplatte gemäß Oberbegriff des Patentanspruches 1.

In DV- und Kommunikationssystemen werden große Datenmengen in Massenspeichern gehalten, auf die über einen Daten-und/oder-Steuerbus, beispielsweise einen sogenannten "SCSI-2"-Daten-/Steuerbus ("Small Computer System Interface-2"), von einer _ Prozessor-Einheit aus zugegriffen werden kann. Ein solcher aus der PC-Welt stammende "SCSI-2"-Daten-/Steuerbus wird zumeist in einem Flachbandkabel von der Prozessor-Einheit ausgehend als Girlande von einem Massenspeicher zum nächsten Massenspeicher geführt und ist an beiden Enden (aktiv oder passiv) durch einen festgelegten Busabschluß abgeschlossen. An den Massenspeichern werden die Bussignale über ein Steckverbinder-System mittels Stichleitungen auf die in dem jeweiligen Massenspeicher vorhandene Leiterplatte geführt.

Sollen nun Massenspeicher in Baugruppenträger von DV- und Kommunikationssystemen mit aufgenommen werden, so wurde dies bisher, insbesondere in der PC-Technik, gelöst, indem die Verbindung der Massenspeicher untereinander und zu einer Prozessor-Baugruppe hin mittels eines Flachbandkabels durchgeführt oder eine elektrisch nicht zulässige Verlängerung einer Stichleitung in Kauf genommen wurde.

Aus der US-Patentschrift 4,811,275 ist ein Baugruppenträger bekannt, in den Massenspeicher integrierbar sind. Allerdings kann dies nur mit einem konstruktiven Mehraufwand erreicht werden.

Es ist nun Aufgabe der vorliegenden Erfindung, einen Weg zu zeigen, wie ein Baugruppenträger der eingangs genannten Art ausgebildet werden kann, um mit einem relativ geringen konstruktiven Aufwand Massenspeicher in einem Baugruppenträger integrieren zu können.

Gelöst wird diese Aufgabe durch die im Patentanspruch 1 aufgeführten konstruktiven Merkmale. Die Erfindung bringt dabei den Vorteil mit sich, daß aufgrund des Verzichts eines oben erwähnten, als Girlande von Baugruppe zu Baugruppe zu führenden Flachbandkabels nicht nur eine Kostenersparnis gegeben ist, sondern gleichzeitig die Störsicherheit eines beispielsweise in einem Baugruppenträger untergebrachten DV- bzw. Kommunikationssystems gegenüber der herkömmlichen Kabel-Bauweise verbessert ist. Dabei sind für die vorgeschlagene Führung von Daten-und/oder-Steuerbussen keine besonderen Rückwandleiterplatten und zusätzliche EMV-Schirmungsmaßnahmen erforderlich. Schließlich sind für den Einbau oder Ausbau von Massenspeichern in oder aus einem Baugruppenträger keine Einschränkungen gegeben bzw. keine umständliche Handhabung erforderlich. Vielmehr können die Massenspeicher enthaltenden Baugruppen in einfacher Weise von der Frontseite des Baugruppenträgers aus wie die übrigen Baugruppen unter Spannung gesteckt bzw. gezogen werden.

Vorteilhafte Ausgestaltungen der vorliegenden Erfindung ergeben sich aus den Patentansprüchen 2 bis 4. Die Vorteile dieser Ausgestaltungen ergeben sich dabei durch einfache konstruktive Maßnahmen, um eine Mehrzahl von Massenspeichern gemeinsam über einen Daten-und/oder-Steuerbus an eine Prozessor-Einheit anschließen zu können. Der Vorteil der Ausgestaltung gemäß Patentanspruch 3 besteht darüber hinaus in der Möglichkeit, beliebige kommerziell erhältliche, beispielsweise aus der PC-Technik bekannte Massenspeicher in die Massenspeicher-Baugruppen einsetzen zu können.

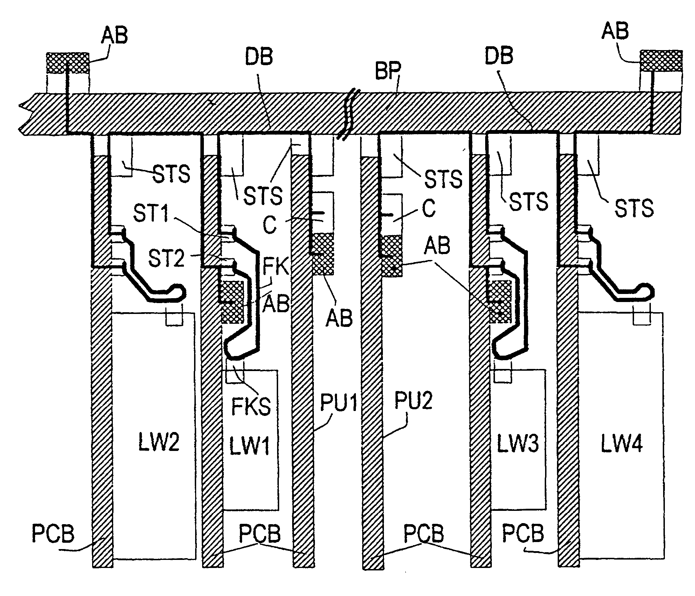

Im folgenden wird die vorliegende Erfindung anhand eines in einer Zeichnung schematisch dargestellten Ausführungsbeispiels näher beschrieben. Dabei sind in der Zeichnung lediglich diejenigen konstruktiven und schaltungstechnischen Elemente dargestellt, die für das Verständnis der vorliegenden Erfindung erforderlich sind.

In der Zeichnung ist ausschnittweise ein Baugruppenträger dargestellt, welcher über eine gedruckte Leiterbahnen führende Rückwandleiterplatte ("backplane") BP verfügt. Diese Rückwandleiterplatte weist Steckverbinder-Elemente auf, in welche über komplementäre Steckverbinder-Elemente elektrische Baugruppen aufnehmbar sind. Zwei zueinander komplementäre Steckverbinder-Elemente werden dabei im folgenden zusammen als Steckverbinder-System STS bezeichnet.

Die genannten Baugruppen, von denen jeweils lediglich eine mit PCB bezeichnete, über elektrische Leiterbahnen verfügende Leiterplatte ("printed circuit board") dargestellt ist, mögen beispielsweise einem DV- bzw. Kommunikationssystem zugehörig sein. Unter derartige Systeme sollen beispielsweise auch PC's fallen. Von diesen Baugruppen ist wenigstens eine als Prozessor-Baugruppe mit einer Prozessor-Einheit ("processor unit") PU1 bzw. PU2 ausgebildet. In der Zeichnung sind zwei derartige Prozessor-Baugruppen angedeutet. Darüber hinaus sind zu jeder der beiden Prozessor-Baugruppen als Beispiel zwei Sonder-Baugruppen durch eine Leiterplatte PCB angedeutet. Diese insgesamt vier dargestellten Sonder-Baugruppen dienen jeweils für die Aufnahme eines Massenspeichers, beispielsweise in Form eines Disketten-Laufwerkes. Dabei sind die auf den einzelnen Sonder-Baugruppen vorgesehenen Massenspeicher mit LW1 bis LW4 bezeichnet. Diese Massenspeicher mögen dabei für die Speicherung und Bereitstellung von Datensignalen bzw. Steuerbefehlsfolgen über Daten-und/oder-Steuerbusse von den zuvor genannten Prozessor-Einheiten PU1 und PU2 her ansteuerbar sein.

Weitere zu dem angenommenen DV-bzw. Kommunikationssystem gehörende Baugruppen sind in der Zeichnung nicht dargestellt, da die Ausbildung dieser Baugruppen nicht Gegenstand der vorliegenden Erfindung ist.

Im folgenden wird die Ausbildung der zuvor erwähnten Daten-und/oder-Steuerbusse näher erläutert. Dabei sei als Beispiel angenommen, daß der jeweilige Daten-und/oder Steuerbus DB als sogenannter "SCSI-2"-Daten-/Steuerbus ("Small Computer System Interface-2"), wie er aus der PC-Welt bekannt ist, realisiert ist. Weiterhin sei angenommen, daß jede der beiden Prozessor-Baugruppen mit ihrer zugehörigen Prozessor-Einheit über einen eigenen "SCSI-2"-Daten-/Steuerbus jeweils mit zwei Massenspeichern verbunden sein mögen. Auf der linken Seite der Zeichnung sind einer mit PU1 bezeichneten Prozessor-Einheit zwei Sonder-Baugruppen mit Massenspeichern LW1 und LW2 zugeordnet. In entsprechender Weise sind auf der rechten Seite der Zeichnung einer mit PU2 bezeichneten Prozessor-Einheit zwei Sonder-Baugruppen mit Massenspeichern LW3 und LW4 zugeordnet. Da diese auf beiden Seiten der Zeichnung vorhandenen Systeme in gleicher Weise hinsichtlich des zugehörigen "SCSI-2"-Daten-/Steuerbusses realisiert sind, wird im folgenden die Realisierung eines solchen "SCSI-2"-Daten-/Steuerbusses lediglich am Beispiel des auf der linken Seite der Zeichnung angedeuteten Systems erläutert.

Von einer der Prozessor-Einheit PU1 zugehörigen, in der Zeichnung mit C bezeichneten Bus-Steuereinrichtung ("SCSI-2-controller") aus verläuft der "SCSI-2"-Daten-/Steuerbus DB zunächst über die Leiterplatte PCB der der Prozessor-Einheit PU1 zugehörigen Prozessor-Baugruppe und das mit dieser verbundene Steckverbinder-System STS zu der Rückwandleiterplatte BP. Von dieser Rückwandleiterplatte aus ist der "SCSI-2"-Daten-/Steuerbus dann dem Steckverbinder-System STS der der Prozessor-Baugruppe benachbarten Massenspeicher-Baugruppe zugeführt. Dabei gelangt dieser über eine erste Kontaktreihe des Steckverbinder-Systems auf die Bestückungsseite der Leiterplatte PCB der betreffenden Massenspeicher-Baugruppe. Von hier aus führt der "SCSI-2"-Daten-/Steuerbus auf der Leiterplatte zu einer Bus-Übergangsstelle, an deren beiden Seiten jeweils ein Flachbandkabel-Steckverbinderelement ST1 bzw. ST2 angelötet ist.

Mit den beiden Flachbandkabel-Steckverbinderelementen ST1 und ST2 ist ein Flachbandkabel FK über zu diesen Flachbandkabel-Steckverbinderelementen komplementäre Flachbandkabel-Steckverbinderelemente verbunden. Innerhalb des Flachbandkabels ist ein weiteres Flachbandkabel-Steckverbinderelement FKS angebracht, welches für den Anschluß des Massenspeichers LW1 mit Hilfe eines komplementären Steckverbinderelementes dient.

Von dem zweiten Flachbandkabel-Steckerverbinderelement ST2 ausgehend, wird der "SCSI-2"-Daten-/Steuerbus nun auf der anderen Leiterplattenseite der dem Massenspeicher LW1 zugehörigen Massenspeicher-Baugruppe geführt, und zwar bis zu der letzten Kontaktreihe des zugehörigen Steckverbindersystems STS. Das Flachbandkabel bildet also eine Bus-Schleife über diese Massenspeicher-Baugruppe.

Von dem gerade genannten Steckverbindersystem STS aus gelangt der "SCSI-2"-Daten-/Steuerbus dann erneut auf die Rückwandleiterplatte BP und dort zu dem Steckverbindersystem STS der dem Massenspeicher LW2 zugehörigen Massenspeicher-Baugruppe. Der "SCSI-2"-Daten-/Steuerbus ist auf dieser dann in der zuvor beschriebenen Weise geführt und anschließend auf die Rückwandleiterplatte BP zurückgeführt.

Der "SCSI-2"-Daten-/Steuerbus ist im übrigen, wie in der Zeichnung angedeutet, entsprechend der Spezifikationsvorgaben auf der genannten, den Anfang des Daten-/Steuerbusses bildenden Prozessor-Baugruppe und an dem auf die Rückwandleiterplatte BP zurückgeführten Ende des Daten-/Steuerbusses jeweils durch einen definierten Busabschluß AB, beispielsweise ein Widerstandsnetzwerk, abgeschlossen. Der auf der mit dem Massenspeicher LW1 bestückten Massenspeicher-Baugruppe vorgesehene Busabschluß AB ist bei einem zuvor gerade erwähnten Busabschluß am Ende des Daten-/Steuerbusses deaktiviert. Eine Aktivierung erfolgt lediglich dann, wenn die den Massenspeicher LW2 enthaltende Massenspeicher-Baugruppe nicht gesteckt ist.

Vorstehend wurde die vorliegende Erfindung am Beispiel eines "SCSI-2"-Daten-/Steuerbusses erläutert. Diese Erfindung ist jedoch nicht auf einen derartigen "SCSI-2"-Daten-/Steuerbus beschränkt, sondern vielmehr allgemein unter Verwendung eines beliebigen Daten-und/oder-Steuerbusses anwendbar. Darüber hinaus kann ein Daten-und/oder-Steuerbus gemäß der vorliegenden Erfindung auch hinsichtlich der Anzahl der anschließbaren Massenspeicher und damit der Buslänge modifiziert sein. Insbesondere kann bei Einsatz eines einzigen Massenspeichers der Daten-und/oder-Steuerbus lediglich bis auf die diesen Massenspeicher enthaltende Massenspeicher-Baugruppe geführt sein und dort gegebenenfalls entsprechend der Bus-Spezifikation mit einem definierten Busabschluß abgeschlossen sein. Außerdem kann auch auf der Leiterplatte einer Massenspeicher-Baugruppe durch gedruckte Leiterbahnen eine Bus-Schleife gebildet sein, und zwar unter Wegfall der oben erwähnten Bus-Übergangsstelle (ST1 und ST2). Eine derartige Vorgehensweise setzt jedoch voraus, daß der jeweilige Massenspeicher mit dem Daten-und/oder-Steuerbus entsprechend verbindbar ist. Dies kann beispielsweise mit Hilfe eines mit dem Daten-und/oder-Steuerbus verbundenen Verbindungs-Elementes realisiert werden, welches intern eine Bus-Schleife realisiert und zusätzlich ein Steckverbinder-Element für den Anschluß eines Massenspeichers aufweist.

## Patentansprüche

1. Baugruppenträger mit einer gedruckte Leiterbahnen führenden Rückwandleiterplatte (BP), in welche über Steckverbinder-Systeme (STS) elektrische Baugruppen lösbar aufgenommen sind, wobei zumindest eine der Baugruppen als Prozessor-Baugruppe über eine Prozessoreinheit (PU1 bzw. PU2) verfügt, welche über einen gesonderten Daten-und/oder-Steuerbus (DB) mit zumindest einem Massenspeicher (LW1,..,LW4) verbindbar ist, der von einer gesonderten Massenspeicher-Baugruppe aufgenommen ist, welche wie die genannten Baugruppen über ein Steckverbinder-System (STS) mit der Rückwandleiterplatte (BP) verbindbar ist, wobei der jeweilige Daten-und/oder-Steuerbus (DB) zumindest weitgehend in Form gedruckter Leiterbahnen von der in Frage kommenden Prozessor-Einheit (PU1 bzw. PU2) aus über die Leiterplatte (PCB) der zugehörigen Prozessor-Baugruppe und dem mit dieser verbundenen Steckverbinder-System zu der Rückwandleiterplatte (BP) und von dort aus über das der genannten Massenspeicher-Baugruppe zugehörige Steckverbinder-System (STS) und die zugehörige Leiterplatte (PCB) zu dem Massenspeicher geführt ist,
**dadurch gekennzeichnet,**
**daß** der von der jeweiligen Prozessor-Einheit her der Rückwandleiterplatte zugeführte Daten-und/oder-Steuerbus DB über jede der Massenspeicher-Baugruppen in Form einer zumindest weitgehend auf der jeweils zugehörigen Leiterplatte als gedruckte Leiterbahnen verlaufenden Bus-Schleife geführt ist und daß der jeweilige Massenspeicher an der Bus-Schleife der zugehörigen Massenspeicher-Baugruppe angeschlossen ist.

2. Baugruppenträger nach Anspruch 1,
**dadurch gekennzeichnet,**
**daß** der jeweilige Daten-und/oder-Steuerbus (DB) auf der Leiterplatte der jeweiligen Massenspeicher-Baugruppe aufgetrennt und an den beiden Bus-Übergangsstellen jeweils ein Flachbandkabel-Steckverbinderelement (ST1 bzw. ST2) vorgesehen ist,
**daß** die beiden Bus-Übergangsstellen über ihre Flachbandkabel-Steckverbinderelemente mit einem an beiden Enden über komplementäre Flachbandkabel-Steckverbinderelemente verfügenden Flachbandkabel (FK) verbunden sind,
und **daß** an dem Flachbandkabel ein weiteres Flachbandkabel-Steckverbinderelement (FKS) vorgesehen ist, an welches der auf der jeweiligen Massenspeicher-Baugruppe vorhandene Massenspeicher (LW!,...,LW4) anschließbar ist.

3. Baugruppenträger nach einem der Ansprüche 1, 2,
**dadurch gekennzeichnet,**
**daß** der jeweilige Daten-und/oder-Steuerbus an seinen beiden Enden jeweils mit einem Busabschluß abgeschlossen ist.

## Claims

1. Mounting rack having a backplane (BP) which has printed conductor tracks and detachably holds electrical assemblies by means of plug connector systems (STS), at least one of the assemblies, as processor assembly, having a processor unit (PU1 or PU2) which can be connected via a separate data and/or control bus (DB) to at least one bulk memory (LW1,..,LW4) held by a separate bulk memory assembly which, like the aforementioned assemblies, can be connected to the backplane (BP) by means of a plug connector system (STS), the respective data and/or control bus (DB) being routed, at least to a large extent in the form of printed conductor tracks, from the relevant processor unit (PU1 or PU2) via the printed circuit board (PCB) of the associated processor assembly and the plug connector system connected thereto to the backplane (BP), and from there via the aforementioned bulk memory assembly's associated plug connector system (STS) and the associated printed circuit board (PCB) to the bulk memory,
**characterized**
**in that** the data and/or control bus (DB) supplied to the backplane from the respective processor unit is routed via each of the bulk memory assemblies in the form of a bus loop running at least to a large extent on the respectively associated printed circuit board as printed conductor tracks,
and **in that** the respective bulk memory is connected to the bus loop of the associated bulk memory assembly.

2. Mounting rack according to Claim 1,
**characterized**
**in that** the respective data and/or control bus (DB) is interrupted on the printed circuit board of the respective bulk memory assembly, and a respective ribbon cable plug connector element (ST1 or ST2) is provided at the two bus junction points,
**in that** the two bus junction points are connected by means of their ribbon cable plug connector elements to a ribbon cable (FK) which has complementary ribbon cable plug connector elements at both ends,
and **in that** the ribbon cable is provided with a further ribbon cable plug connector element (FKS), to which the bulk memory (LW1, ..., LW4) provided on the respective bulk memory assembly can be connected.

3. Mounting rack according to one of Claims 1, 2,
**characterized**
**in that** the two ends of the respective data and/or control bus are each terminated with a bus termination.

## Revendications

1. Châssis comportant un fond de panier (BP) qui guide des pistes conductrices imprimées et dans lequel des modules électriques sont reçus de manière amovible par l'intermédiaire de systèmes (STS) de connecteur, au moins l'un des modules disposant comme module de processeur d'une unité (PU1 et PU2) de processeur qui peut être reliée par l'intermédiaire d'un bus (DB) de données et/ou de commande distinct à au moins une mémoire (LW1, ..., LW4) de fond qui est reçue par un module de mémoire de masse distinct qui peut être relié, comme les modules mentionnés, au fond de panier par l'intermédiaire d'un système (STS) de connecteur, le bus (DB) de données et/ou de commande associé étant guidé au moins dans une grande mesure sous la forme de pistes conductrices imprimées de l'unité (PU1 et PU2) de processeur en question, par l'intermédiaire de la plaquette (PCB) à circuit imprimé du module de processeur associé et du système de connecteur qui y est relié, au fond de panier (BP) et de là, par l'intermédiaire du système (STS) de connecteur associé auxdits modules de mémoire de masse et par l'intermédiaire de la plaquette (PCB) à circuit imprimé associé, à la mémoire de masse,
**caractérisé en ce que** le bus (DB) de données et/ou de commande amené de l'unité de processeur associée au fond de panier est guidé, par l'intermédiaire de chacun des modules de mémoire de masse sous la forme d'une boucle de bus s'étendant comme pistes conductrices imprimées au moins dans une grande mesure sur la plaquette à circuit imprimé associée et **en ce que** la mémoire de masse associée est raccordée à la boucle de bus du module de mémoire de masse associé.

2. Châssis suivant la revendication 1, **caractérisé en ce que** le bus (DB) de données et/ou de commande associé est séparé sur la plaquette à circuit imprimé du module de mémoire de mémoire de masse associé et **en ce qu'**il est prévu aux deux points de transition de bus chaque fois un élément (ST1 et ST2) connecteur de câbles en ruban plat,
**en ce que** les deux points de transition de bus sont reliés par l'intermédiaire de leurs éléments connecteurs de câble à ruban plat à un câble (FK) à ruban plat disposant d'éléments connecteurs de câbles à ruban plat complémentaires,
et **en ce qu'**il est prévu sur le câble à ruban plat un élément (FKS) connecteur de câble à ruban plat supplémentaire auquel peut être raccordée la mémoire (LW1, ..., LW4) de fond présente sur le module de mémoire de masse associé.

3. Châssis suivant l'une des revendications 1, 2, **caractérisé en ce que** le bus de données et/ou de commande est terminé à ses deux extrémités chaque fois par une terminaison de bus.
